# EUROPEAN PATENT SPECIFICATION

(11) **EP 2 099 075 B1**
(45) Date of publication and mention of the grant of the patent: **09.09.2015**
(21) Application number: 09153975.9
(22) Date of filing: 27.02.2009
(51) Int. Cl.: H01L 31/0224, H01L 31/072, H01L 31/0352, H01L 31/075

(54) **Photovoltaic device**
Photovoltaische Vorrichtung
Dispositif photovoltaïque

(30) Priority: 07.03.2008 CN 200810065797; 03.04.2008 CN 200810066508; 03.04.2008 CN 200810066509; 18.04.2008 CN 200810066750; 03.04.2008 CN 200810066504; 18.04.2008 CN 200810066749
(43) Date of publication of application: 09.09.2009
(73) Proprietor: Tsing Hua University, Haidian District Beijing (CN); Hon Hai Precision Industry Co., Ltd., Tu-cheng City, Taipei Hsien (TW)
(72) Inventor: Sun ,Hai-Lin, Haidian District Beijing (CN); Jiang, Kai-Li, Haidian District Beijing (CN); Li, Qun-Qing, Haidian District Beijing (CN); Fan, Shou-Shan, Haidian District Beijing (CN)
(74) Representative: Huang, Chongguang

(56) References cited:
- WO-A2-2004/068548
- US-A1- 2004 177 878
- US-A1- 2007 273 264
- WU Z ET AL: "TRANSPARENT, CONDUCTIVE CARBON NANOTUBE FILMS", SCIENCE, AMERICAN ASSOCIATION FOR THE ADVANCEMENT OF SCIENCE, WASHINGTON, DC; US, vol. 305, no. 5688, 27 August 2004 (2004-08-27), pages 1273-1276, XP008037705, ISSN: 0036-8075, DOI: DOI:10.1126/SCIENCE.1101243
- J. WEI, Y. JIA, Q. SHU, Z. GU, K. WANG, D. ZHUANG, G. ZHANG, Z. WANG, J. LUO, A. CAO, D. WU: "Double-Walled Carbon Nanotube Solar Cells", NANO LETTERS, vol. 7, no. 8, 7 March 2007 (2007-03-07), pages 2317-2321, XP002634700, Web
- M. A. CONTRERAS ET AL.: "Replacement of Transparent Conductives Oxides by Single-Wall Carbon Nanotubes in Cu(In,Ga)Se2 - Based Solar Cells", THE JOURNAL OF PHYSICAL CHEMISTRY C LETTERS, vol. 111, 9 June 2007 (2007-06-09), pages 14045-14048, XP002635339,

## Description

The invention relates to energy conversion devices, and particularly to a photovoltaic device.

Currently, solar energy is considered as a renewable and clean energy source, and can be used as an alternative source of energy other than fossil fuel. Solar energy is generally produced by photovoltaic cells, also known as solar cells. The photovoltaic cell or the solar cell is a device that converts light into electrical energy using the photoelectric effect.

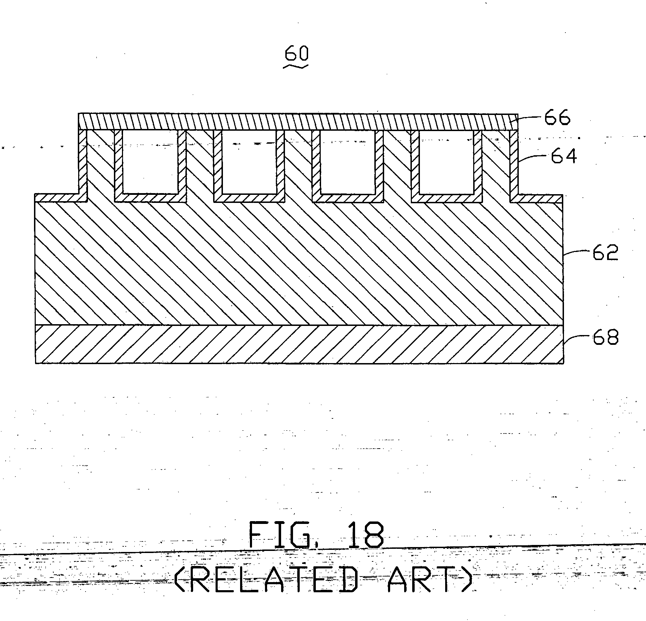

Generally, the solar cell includes a large-area p-n junction made from silicon. Silicon employed in the solar cell can be single crystal silicon or polycrystalline silicon. Referring to FIG. 18, a conventional solar cell 60 according to the prior art generally includes a silicon substrate 62, a doped silicon layer 64, a front electrode 66, and a rear electrode 68. The doped silicon layer 64 is formed in intimate contact with the silicon substrate 62 to form a p-n junction. The front electrode 66 is located on and electrically connected to the doped silicon layer 64. The rear electrode 68 is located on and electrically connected to, e.g. via ohmic contact, the silicon substrate 62. In use, the electrodes 66, 68 are connected to an external load. Current will be generated and flow in one direction across the p-n junction by the action of the electric field if light strikes the solar cell 60.

Generally, the electrodes 66, 68 are made of conductive metals, such as aluminum (Al), silver (Ag) or copper (Cu), which are usually not transparent to light. Therefore, the electrode 66, 68, in particular, the front electrode 66 is fabricated in a finger-shape or a comb-shape to increase amount of incoming light that can pass by the electrode. Moreover, in order to enhance photoelectric conversion efficiency, transparent conductive material, e.g. indium tin oxide (ITO), may instead be selected to form the front electrode 66. However, ITO material has drawbacks of, for example, being not chemically and mechanically durable, and having ununiform distribution of resistance. As a result, the durability and the photoelectric conversion efficiency are relatively low for devices using transparent conductive materials.

What is needed, therefore, is a photovoltaic device that is more efficient and durable.

Many aspects of the present photovoltaic device can be better understood with references to the following drawings. The components in the drawings are not necessarily drawn to scale, the emphasis instead being placed upon clearly illustrating the principles of the present photovoltaic device.
FIG. 1 is a schematic, side view of a photovoltaic device, in accordance with an example not part of the invention.
FIG. 2 is a schematic, top view of the photovoltaic device of FIG. 1.
FIG. 3 is a Scanning Electron Microscope (SEM) image of a carbon nanotube film.
FIG. 4 is a schematic view of a carbon nanotube segment of the carbon nanotube film of FIG. 3.
FIG. 5 is a schematic view showing a plurality of carbon nanotube wires arranged in bundle form according to an example.
FIG. 6 is a schematic view showing a plurality of carbon nanotube wires arranged in twisted form according to an example.
FIG. 7 is a Scanning Electron Microscope (SEM) image of an untwisted carbon nanotube wire.
FIG. 8 is a Scanning Electron Microscope (SEM) image of a twisted carbon nanotube wire.
FIG. 9 is a schematic, side view of a photovoltaic device, in accordance with an embodiment.
FIG. 10 is a schematic view of the carbon nanotube composite structure according to an exemplary embodiment.
FIG. 11 is a schematic, side view of a photovoltaic device, in accordance with an example not part of the invention.
FIG. 12 is a schematic, top view of the photovoltaic device of FIG. 11.
FIG. 13 is a schematic enlarged view showing a portion of a silicon substrate of the photovoltaic device of FIG. 11.
FIG. 14 is a schematic enlarged view showing portions of the silicon substrate and the carbon nanotube of the photovoltaic device of FIG. 11.
FIG. 15 is a schematic, side view of a photovoltaic device, in accordance with an example not part of the invention.
FIG. 16 is a schematic, top view of the photovoltaic device of FIG. 15.
FIG. 17 is a schematic, side view of a photovoltaic device, in accordance with an example not part of the invention.
FIG. 18 is a schematic view of a conventional photovoltaic device according to the Prior Art.

Corresponding reference characters indicate corresponding parts throughout the several views. The exemplifications set out herein illustrate at least one embodiment of the photovoltaic device, in at least one form, and such exemplifications are not to be construed as limiting the scope of the invention in any manner.

References will now be made to the drawings, in detail, to describe embodiments of the photovoltaic device.

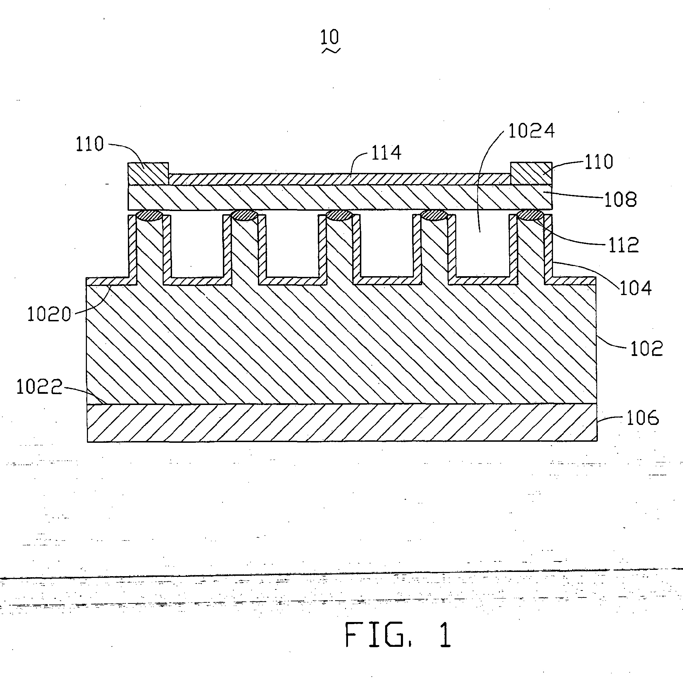

Referring to FIG. 1, a photovoltaic device 10 according to a first example, not part of the invention is shown. The photovoltaic device 10 includes a silicon substrate 102, a doped silicon layer 104, a first electrode 106, and a second electrode 108.

The silicon substrate 102 is made of single crystal silicon. Particularly, the silicon substrate 102 is p-type single crystal silicon. A thickness of the silicon substrate 102 is in a range from about 200µm to about 300µm. The silicon substrate 102 has a front surface 1020 and a rear surface 1022. The front surface 1020 of the silicon substrate 102 has a plurality of cavities 1024 defined therein. That is, some portions of the front surface 1020 form the cavities 1024 for enhancing light collation and increasing the area of p-n junction formation. The cavities 1024 are distributed uniformly and are spaced from each other by a distance in a range from about 10µm to about 30µm. In addition, a depth of each of the cavities 1024 is in a range from about 50µm to about 70µm. However, in other example, the cavities 1024 may vary in shape and dimension. While a squared cross section is shown, any concave surface can be used. For example, the cross section of each of the cavities 1024 can be square, trapezoidal, triangular, circular or other shapes. In the present example, the cavities 1024 are equidistantly spaced about 20µm apart and each cavity 1024 has a depth of about 60µm. The cross sections of cavities 1024 are square-shaped.

The doped silicon layer 104 is formed in contact the silicon substrate 102 to form a p-n junction between the doped silicon layer 104 and the silicon substrate 102. Namely, the doped silicon layer 104 is located on the front surface 1020 of the silicon substrate 102 and, in particular, is located on inside walls of each cavity 1024. In the present embodiment, the doped silicon layer 104 is n-type silicon made by adding an abundance of dopant, such as phosphorus (P) or arsenic (As), into the silicon substrate 102. In addition, a thickness of the doped silicon layer 104 is in a range from about 500nm to about 1µm. Thus, a plurality of p-n junctions are formed between the n-type doped silicon layer 104 and the p-type single crystal silicon substrate 102, achieving light radiation to electrical energy conversions.

The first electrode 106 is attached to the rear surface 1022 of the silicon substrate 102. The first electrode 106 is made of metal, such as aluminum, magnesium or silver, and has a thickness ranging from about 10µm to about 300µm.

The second electrode 108 is adjacent to the front surface 1020 of the silicon substrate 102. The second electrode 108 includes a carbon nanotube structure. The carbon nanotube structure includes a plurality of carbon nanotubes distributed uniformly therein. A plurality of carbon nanotubes are arranged orderly or disorderly in the carbon nanotube structure. When the carbon nanotube structure includes a plurality of carbon nanotubes arranged disorderly, the carbon nanotubes are entangled with each other. When the carbon nanotube structure includes a plurality of carbon nanotubes arranged orderly, the carbon nanotubes are primarily oriented along a same direction or along two or more directions. The carbon nanotubes in the carbon nanotube structure can be selected from a group consisting of single-walled carbon nanotubes, double-walled carbon nanotubes, and multi-walled carbon nanotubes.A diameter of each single-walled carbon nanotube ranges from about 0.5 to about 50 nanometers. A diameter of each double-walled carbon nanotube ranges from about 1 to about 50 nanometers. A diameter of each multi-walled carbon nanotube ranges from about 1.5 to about 50 nanometers. A length of the carbon nanotubes is larger than about 50 micrometers. A length of the carbon nanotubes ranges from about 200 to about 900 micrometers in the first example.

The carbon nanotube structure includes at least one carbon nanotube film, at least one carbon nanotube cable or combination thereof. In the present example, the carbon nanotube structure is a planar structure. When the carbon nanotube-structure includes only one carbon nanotube cable, the single carbon nanotube cable can be folded or circumvoluted to form a planar carbon nanotube structure. When the carbon nanotube structure includes a plurality of carbon nanotube cables, the carbon nanotube cables can be located side by side, crossed, or weaved together to form a planar carbon nanotube structure. When the carbon nanotube structure includes a plurality of carbon nanotube films, the carbon nanotube films can be overlapped or stacked with each other to form a planar carbon nanotube structure. The area and thickness of the carbon nanotube structure are unlimited and could be made according to user's specific needs. The carbon nanotube structure has a free-standing structure. The free-standing structure means the carbon nanotube structure can keep a certain shape without any supporter.

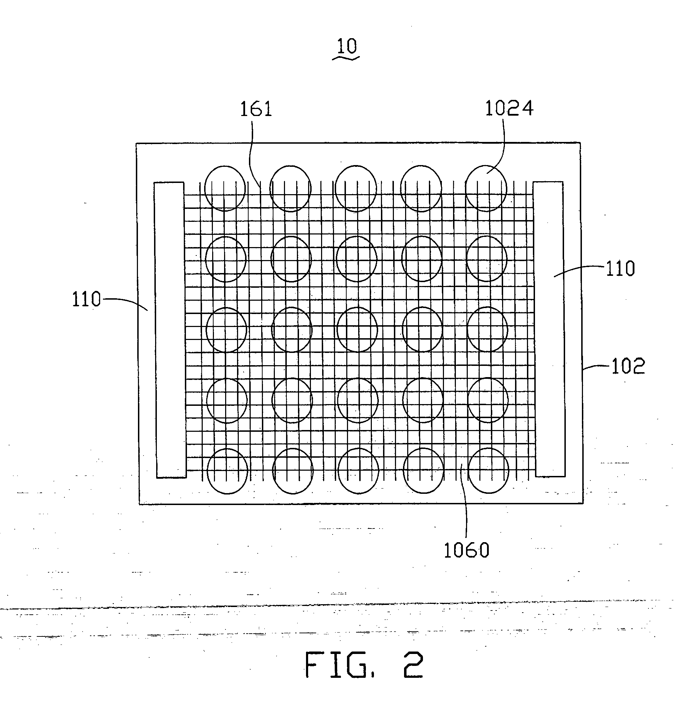

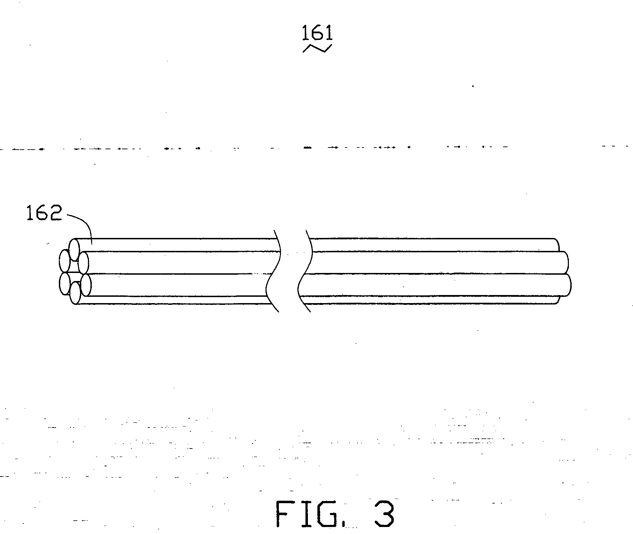

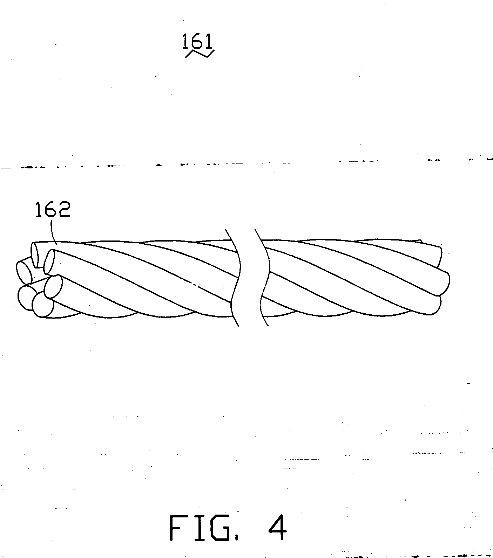

Referring to FIG. 2, in the present example, the carbon nanotube structure includes a plurality of carbon nanotube cables 161. Particularly, the carbon nanotube cables 161 are arranged to be substantially parallel to each other. The carbon nanotube cables 161 are spaced from each other by a distance ranging from about 10µm to about 30µm on the front surface 1020. Suitably, the carbon nanotube cables 161 are equidistantly spaced about 20µm apart, allowing relatively greater amount of incoming light to penetrate into the silicon substrate 102. Referring to FIGS. 3 and 4, each carbon nanotube cable 161 includes a plurality of carbon nanotube wires 162. The carbon nanotube wires 162 can be arranged in bundled structure, as shown in FIG. 3, or in twisted structure, as shown in FIG. 4. Each carbon nanotube wire 162 can be twisted or untwisted.

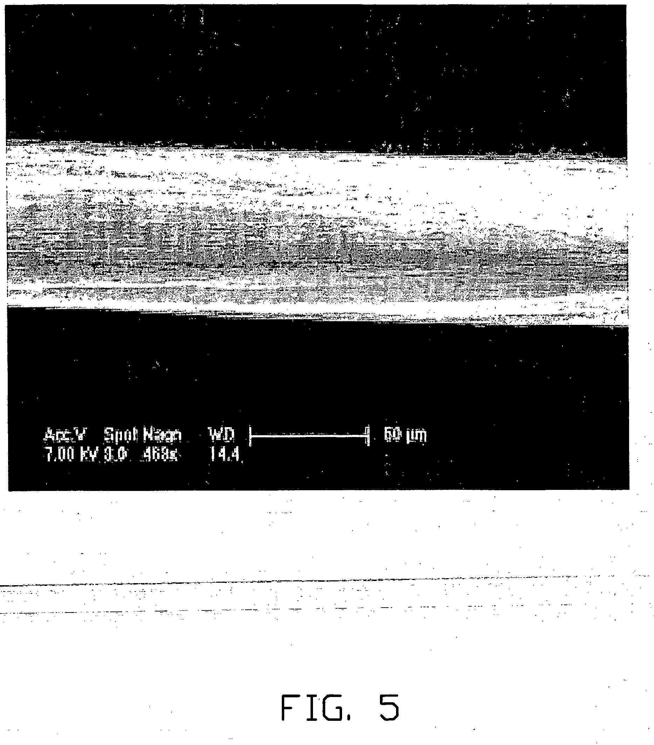

The untwisted carbon nanotube wire is formed by treating the drawn carbon nanotube film with an organic solvent. Specifically, the drawn carbon nanotube film is treated by applying the organic solvent to the drawn carbon nanotube film to soak the entire surface of the drawn carbon nanotube film. After being soaked by the organic solvent, the adjacent parallel carbon nanotubes in the drawn carbon nanotube film will bundle together, due to the surface tension of the organic solvent when the organic solvent volatilizing, and thus, the drawn carbon nanotube film is shrunk into untwisted carbon nanotube wire. The organic solvent is volatile. Referring to FIG. 5, the untwisted carbon nanotube wire includes a plurality of carbon nanotubes substantially oriented along a same direction (e.g., a direction along the length of the untwisted carbon nanotube wire). The carbon nanotubes are parallel to the axis of the untwisted carbon nanotube wire. Length of the untwisted carbon nanotube wire can be set as desired. A diameter of the untwisted carbon nanotube wire is in a range from about 0.5 nanometers to about 100 micrometers.

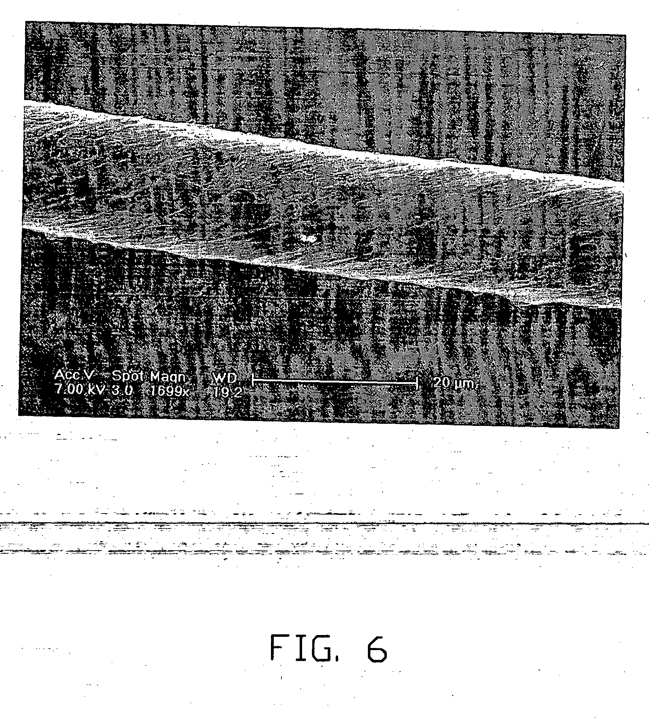

The twisted carbon nanotube wire is formed by twisting a drawn carbon nanotube film by using a mechanical force to turn the two ends of the carbon nanotube film in opposite directions. Referring to FIG. 6, the twisted carbon nanotube wire includes a plurality of carbon nanotubes oriented around an axial direction of the twisted carbon nanotube wire. The carbon nanotubes are aligned around the axis of the carbon nanotube twisted wire like a helix.

Alternatively, referring to FIG. 2, the carbon nanotube cables 161 can form a net like structure. In the present example, some of the carbon nanotube cables 161 are arranged to be parallel and some of the carbon nanotube cables 161 are arranged to be orthogonal to each other, so that the net like structure define a plurality of spaces 1060 that allow the light passing through. The spaces 1060 are distributed uniformly and a dimension of each of the spaces 1060 ranges from about 1nm² to about 20µm². Thus, the uniform net structure of carbon nanotube cables 161 improves the photovoltaic device 10 with uniform distribution of resistance. In such case, at least one portion of the carbon nanotube cables 161 is electrically connected to the third electrodes 110. Thus, the third electrodes 110 are configured to collect current flowing through the net like structure of the carbon nanotube cables 161.

In the example, the carbon nanotube cables 161 can be directly adhered on the front surface 1020 of the silicon substrate 102 due to the carbon nanotubes having a high purity and large surface area.

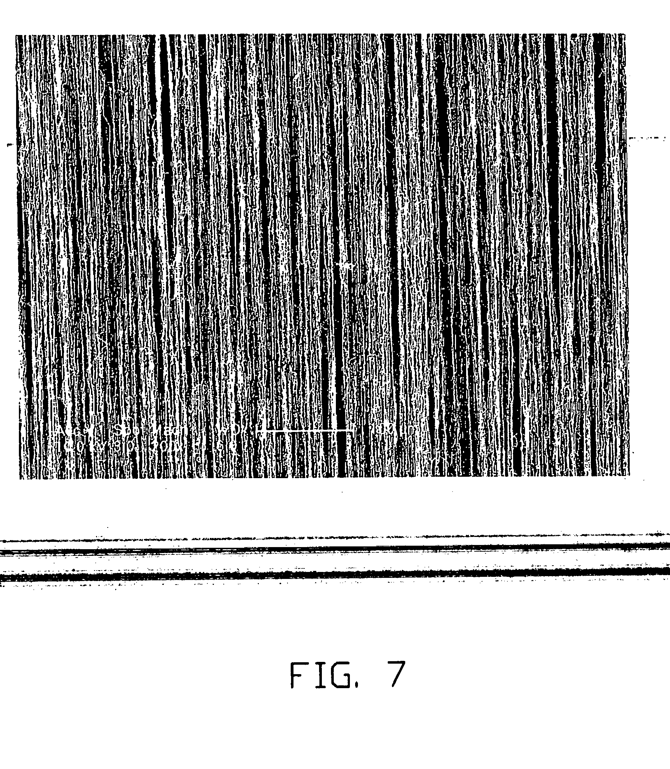

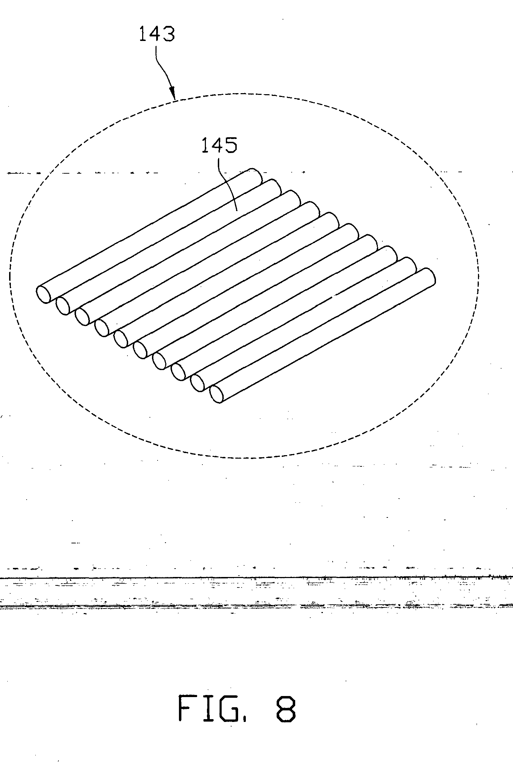

In the other example, the carbon nanotube structure includes one carbon nanotube film. Referring to FIGS. 7 and 8, each carbon nanotube film includes plurality of successively oriented carbon nanotube segments 143 joined end-to-end by van der Waals attractive force therebetween. Each carbon nanotube segment 143 includes a plurality of carbon nanotubes 145 parallel to each other, and combined by van der Waals attractive force therebetween. The carbon nanotube segments 143 can vary in width, thickness, uniformity and shape. The carbon nanotubes 145 in the carbon nanotube film are also oriented along a preferred orientation.

The carbon nanotube film can be pulled out from a super-aligned carbon nanotube array on a substrate. The width and length of the carbon nanotube film is dependent on a size of the carbon nanotube array. In one embodiment, when the substrate is a 4-inch P-type silicon wafer as in the present embodiment, the width of the carbon nanotube film is in a range from about 0.5 nanometers to about 10 centimeters, and the thickness of the carbon nanotube film is in a range from about 0.5 nanometers to about 100 micrometers. The length of the carbon nanotube film can be larger than 10 meters.

Alternatively, the carbon nanotube structure can include at least two stacked carbon nanotube films. Adjacent two carbon nanotube films combine with each other by van der Waals attractive force therebetween. An angle α between the preferred orientations of the carbon nanotubes in the two adjacent carbon nanotube films is in a range of 0≦ α≦ 90°. Thus, the carbon nanotube structure includes a plurality of micropores defined by the stacked carbon nanotube films. The micropores of the present embodiment are distributed in the carbon nanotube structure uniformly. Diameters of the micropores range from about 1 to about 500 nanometers. It is to be understood that there can be some variation in the carbon nanotube structure.

Case in this example, the photovoltaic device 10 further includes a pair of third electrodes 110 electrically connected to the second electrode 108 for collecting current flowing through the second electrode 108. In the present embodiment, the third electrodes 110 are spaced and located above the silicon substrate 102. The third electrodes 110 can be located on any side of the second electrode 108. The carbon nanotube cables 161 extend from one of the third electrodes 110 to the other of the third electrodes 110. The third electrodes 110 are made of metal, such as copper, silver, gold or aluminium.

The photovoltaic device 10 of the present example can further include a plurality of metal strips 112 located between the front surface 1020 of the silicon substrate 102 and the second electrode 108. The metal strips 112 including aluminum or silver are electrically connected to the second electrode 108 and the silicon substrate 102. Due to the disposition of the metal strips 112, the conductivity between the silicon substrate 102 and the second electrode 108 is enhanced. As a result, energy conversion efficiency of the photovoltaic device 10 is improved.

Furthermore, the photovoltaic device 10 of the present example can further include an anti-reflection layer 114 located on the second electrode 108. The anti-reflection layer 114 is configured to reduce light striking on the second electrode 108 to reflect, causing the energy conversion efficiency to be enhanced. In the present embodiment, the anti-reflection layer 114 is made of titanium dioxide or zinc aluminum oxide.

The light irradiates the cavities 1024 of the photovoltaic device 10 through interspaces between the adjacent carbon nanotubes. Next, the light can be repeatedlyreflected by the inner surfaces of the cavities 1024, and as a result, the light absorption of the front surface 1020 of the silicon substrate 102 is improved. A plurality of p-n junctions that receive impinging radiation are formed at the interface of the p-type silicon substrate and the n-type doped silicon layer. Radiated photos create mobile carriers (hole-electron pairs), and the hole-electron pairs are separated to form a plurality of holes and electrons by the electrostatic potential energy. The electrons in the n-type doped silicon layer move to the carbon nanotube structure, and the holes in the p-type silicon substrate move to the first electrode 106. Finally, the holes are collected by the first electrode 106 and the electrons are collected by the third electrode 110, and an electric current goes through an electrical circuit (not shown) outside of the photovoltaic

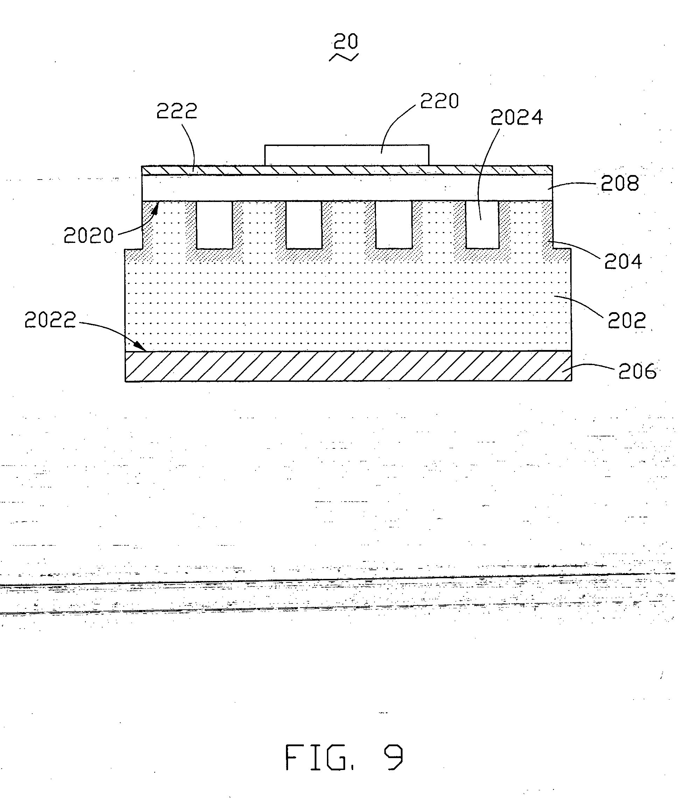

Referring to FIG. 9, a photovoltaic device 20 according to an embodiment according to the invention is shown. The photovoltaic device 20 includes a silicon substrate 202, a doped silicon layer 204, a first electrode 206, and a second electrode 208. The silicon substrate 202 has a front surface 2020 and a rear surface 2022. The front surface 2020 of the silicon substrate 202 defines a plurality of cavities 2024. The photovoltaic device 20 has a structure similar to the photovoltaic device 10 in the first embodiment except that the second electrode 208 includes a carbon nanotube composite structure comprised of a carbon nanotube structure and a plurality of metal particles dispersed therein. The carbon nanotube composite structure is configured for collecting current generated at the p-n junctions based on photoelectric conversion.

The carbon nanotube structure is the same as the carbon nanotube structure provided in the first embodiment. In the present embodiment, the metal particles are uniformly dispersed in the carbon nanotube structure. The metal particles can be selected from the group consisting of platinum (Pt) particles, palladium (Pd) particles, ruthenium (Ru) particles, silver (Ag) particles, gold (Au) particles, alloys thereof particles and combinations thereof. Average diameter of the metal particles is in a range from about 1nm to about 10nm. A mass percentage of the metal particles in the carbon nanotube composite structure is in a range from about 10% to about 30%.

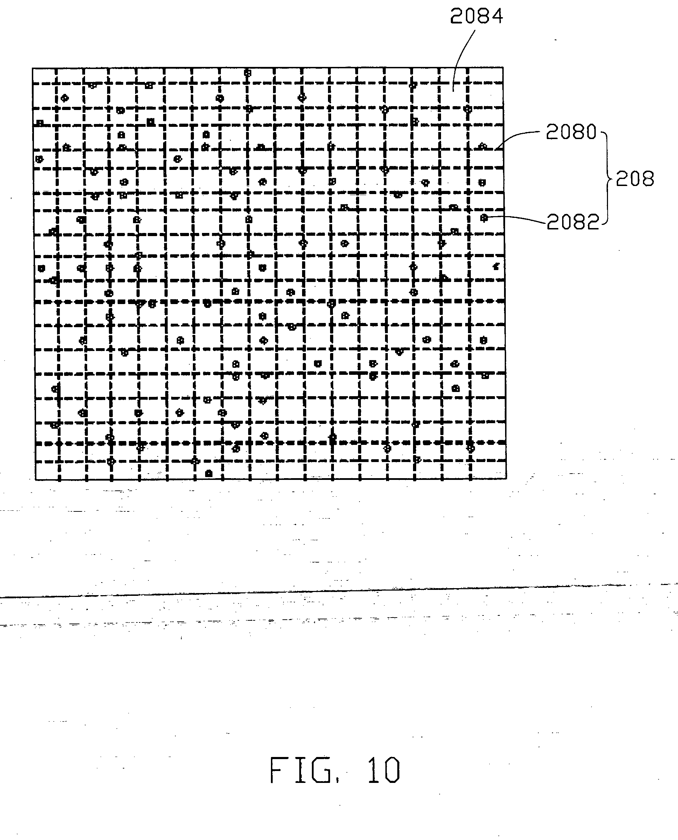

Referring to FIG. 10, in the present embodiment, the second electrode 208 includes two stacked carbon nanotube films 2080 and a plurality of metal particles 2082 dispersed therein. An angle α between the preferred orientations of the carbon nanotubes in the two adjacent carbon nanotube films 2080 is 90°. Thus, a plurality of spaces 2084 is defined. The spaces 2084 are distributed uniformly and a dimension of each of the spaces 2084 ranges from about 1nm² to about 20µm².

Alternatively, the second electrode 208 includes a plurality of carbon nanotube composite cables. The carbon nanotube composite cable comprise a carbon nanotube cable and metal dispersed therein. The metal is in a form of wire, powder or both thereof. For example, a plurality of carbon nanotube wires can be combined together and interlaced with a plurality of metal threads to form the carbon nanotube cable. In such case, the metal threads can be made of gold, silver, or copper. Moreover, the carbon nanotube cables can be obtained by evenly mixing metal powder, such as gold, silver, or copper powder into the carbon nanotube films before treatment with solvent.

In use, when light strikes on the photovoltaic device 20, one portion of incoming light passes through the spaces 2084 and is incident into the cavities 2024 while the other portion of incoming light shines on the second electrode 208. For the portion of incoming light passing through the spaces 2084, the light will be trapped through multiple reflections within the cavities 2024. The light absorption is increased and the efficiency of the photovoltaic device 20 is greatly enhanced.

For the portion of incoming light shining on the second electrode 208, surface plasma are observed on the metal particles as light shines onto the surfaces of metal particles of the second electrode 208. The surface plasma then can be excited by the light and interacted with the light to result in a polariton. A phenomenon of surface plasma resonance is generated, i.e. surface plasma is excited to be in resonance with the incoming light of a predetermined frequency. By way of the surface plasma resonance on the metal particles, the incoming light again irradiates from the metal particles and is incident into the cavities 2024. As a result, the absorption of light for the photovoltaic device 20 is increased.

Furthermore, the photovoltaic device 20 of the present embodiment can further include an anti-reflection layer 222 located on the surface of the second electrode 208 departing from the silicon substrate 202. The anti-reflection layer 222 is configured to reduce light striking on the second electrode 208 to reflect, causing the energy conversion efficiency to be enhanced. In the exemplary embodiment, the anti-reflection layer 222 is made of titanium dioxide or zinc aluminum oxide.

In the present embodiment, the photovoltaic device 20 further includes at least one third electrode 220 electrically connected to the second electrode 208 for collecting current flowing through the second electrode 208. The third electrodes 220 are made of metal such as copper, silver, gold or aluminium.

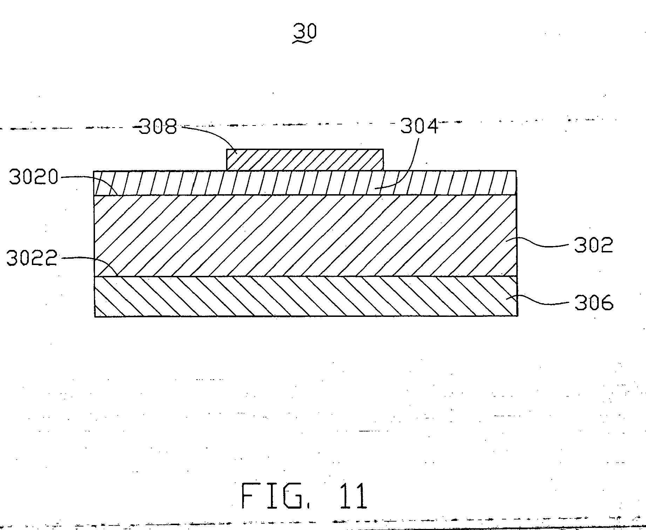

Referring to FIG. 11, a photovoltaic device 30 not part of the invention is shown. The photovoltaic device 30 includes a silicon substrate 302, a first electrode 306, and a carbon nanotube structure 304.

The silicon substrate 302 is made of polycrystalline silicon. The polycrystalline silicon includes a plurality of p-n junctions dispersed therein. The silicon substrate 302 has a front surface 3020 and a rear surface 3022 as shown in FIG. 11. A thickness of the silicon substrate 302 is in a range from about 200µm to about 300µm.

The carbon nanotube structure 304 is the same as the carbon nanotube structure provided in the first example. Particularly, the carbon nanotube structure 304 is formed in intimate contact with the silicon substrate 302, the point of contact forming a heterostructure. The carbon nanotube structure 304 is configured to absorb light and the light is converted to electrical energy via the heterostructure under the photovoltaic effect.

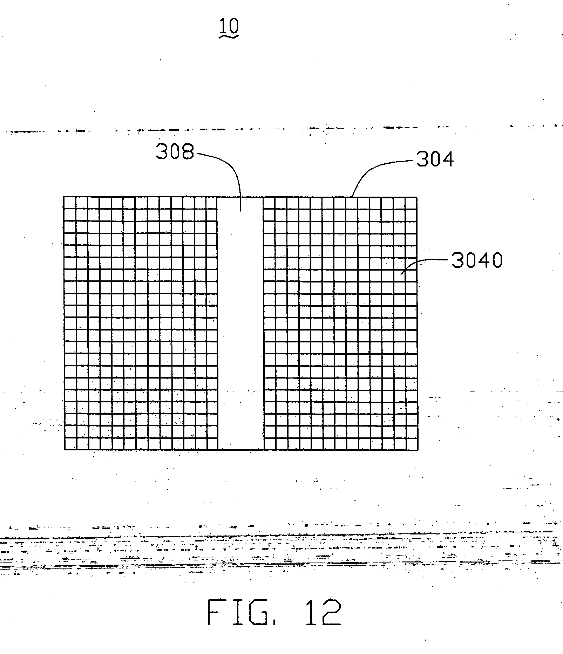

Referring to FIG. 12, the carbon nanotube structure 304 includes two stacked carbon nanotube films. An angle α between the preferred orientations of the carbon nanotubes in the two adjacent carbon nanotube films is 90°. Thus a plurality of spaces 3040 is defined. The spaces 3040 are distributed uniformly and a dimension of each of the spaces 3040 from about 1nm² to about 20µm².

Alternatively, the carbon nanotube structure 304 includes a carbon nanotube composite structure. The carbon nanotube composite structure is the same as the carbon nanotube composite structure provided in the embodiment. The carbon nanotube composite structure can be formed by coating a composited material of a mixture of carbon nanotube powders and metal powders on the silicon substrate 302.

The first electrode 306 is located on and contacts with the rear surface 3022 of the silicon substrate 302, as shown in FIG. 11. The first electrode 306 can be made of metal, such as aluminum, magnesium or silver. In addition, the first electrode 306 has a thickness in a range from about 10µm to about 300µm.

Due to the excellent electrically conductive properties of the carbon nanotubes, the photovoltaic device 30 can have only one electrode. The photovoltaic device 30 can further include a second electrode 308 located on the carbon nanotube structure 304. Alternatively, the second electrode 308 also can be located on and contact with the rear surface 3022 of the silicon substrate 302. The second electrode 308 can be made of conductive material, such as silver, gold or copper. The second electrode 308 can vary in thickness and shape.

In use, light strikes the front surface 3020 of the photovoltaic device 30, radiated photos are absorbed by the carbon nanotube structure 304 and create a lot of mobile carriers (hole-electron pairs) at the heterostructure formed by the interface of the silicon substrate 302 and the carbon nanotube structure 304. Then, the hole-electron pairs are separated to form a plurality of holes and electrons by the electrostatic potential energy. The holes move across the silicon substrate 302 to the first electrode 306 and are collected by the first electrode 306. The electrons are transmitted and collected by the carbon nanotube structure 304. The electrons can further be collected by the second electrode 308. As a result, an electric current goes through an electrical circuit outside of the photovoltaic device 30.

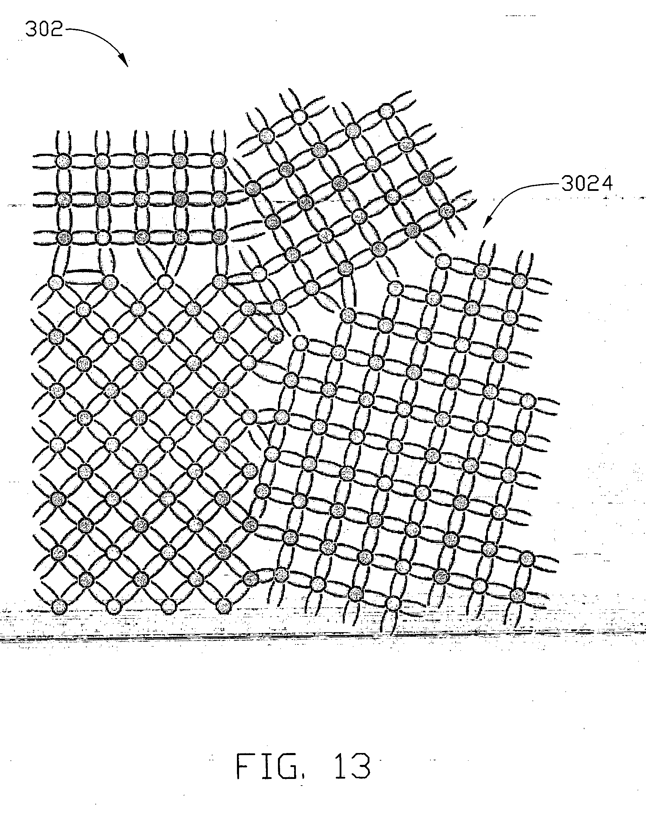

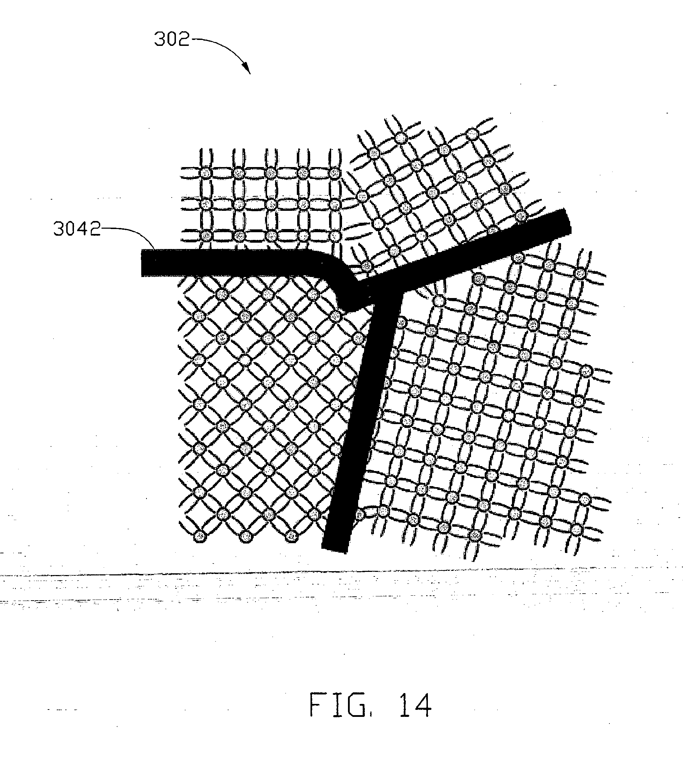

Referring to FIGS. 13 and 14, because the polycrystalline silicon substrate 302 has unsaturated dangling bonds at grain-boundaries 3024 thereof, the carbon nanotube 3042 of the carbon nanotube structure 304 easily adheres to the front surface 3020 of the silicon substrate 302 through a reaction of the carbon nanotube 3042 and the unsaturated dangling bonds. Thus, no adhesive is required. In addition, the generated mobile carriers will be prevented from being captured by the unsaturated dangling bonds. As a result, the energy conversion efficiency and the mobility of electrons will be improved.

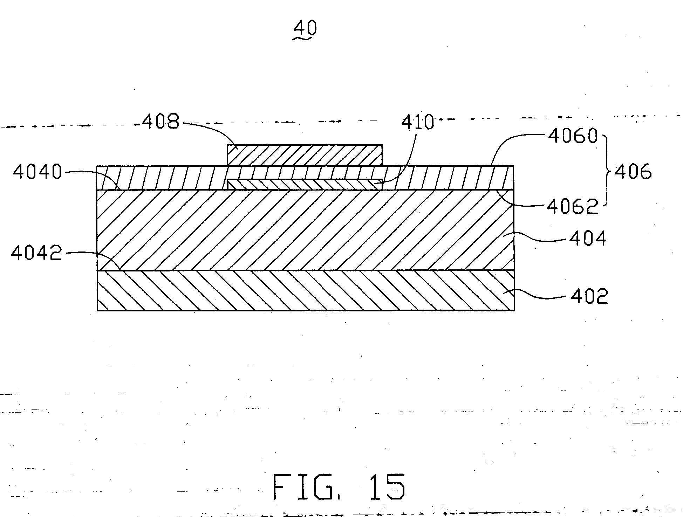

Referring to FIG. 15, a photovoltaic device 40 not part of the invention is shown. The photovoltaic device 40 includes a first electrode 402, a single crystal silicon substrate 404 and a carbon nanotube structure 406. The single crystal silicon substrate 404 includes a front surface 4040 and a rear surface 4042. The first electrode 402 is located on and electrically connected to the rear surface 4042 of the single crystal silicon substrate 404. The carbon nanotube structure 406 is located on and connected to the front surface 4040 of the single crystal silicon substrate 404. The carbon nanotube structure 406 includes a front surface 4060 and a rear surface 4062.

The single crystal silicon substrate 404 can be a P-type single crystal silicon substrate or an N-type single crystal silicon substrate. A thickness of the single crystal silicon substrate 404 ranges from about 200 to about 300 microns.

The first electrode 402 is made of silver, aluminum, magnesium or any other suitable material. A thickness of the first electrode 402 ranges from about 10 to about 300 microns. The shape and thickness of the first electrode 402 can be set as desired.

The carbon nanotube structure 406 is the same as the carbon nanotube structure provided in the first embodiment. A plurality of heterojunctions is formed between the single crystal silicon substrate 404 and the carbon nanotube structure 406, achieving a conversion of solar radiation into electrical energy.

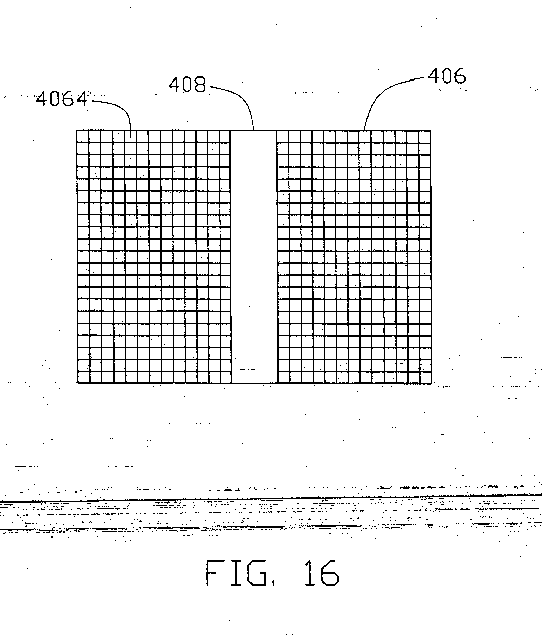

Referring to FIG. 16, the carbon nanotube structure 406 includes two stacked carbon nanotube films. An angle α between the preferred orientations of the carbon nanotubes in the two adjacent carbon nanotube films is equal to 90°. Thus a plurality of spaces 4064 is defined that allow the light passing through.

Furthermore, a plurality of metal particles can be dispersed in the carbon nanotube structure 406 to form a carbon nanotube composite structure. The carbon nanotube composite structure is the same as the carbon nanotube composite structure provided in the second embodiment. The carbon nanotube composite structure can be formed by coating a composited material of a mixture of carbon nanotube powders and metal powders on the silicon substrate 406.

Due to the excellent electrically conductive properties of the carbon nanotubes, the photovoltaic device 40 can have only one electrode. The photovoltaic device 40 can further include at least one second electrode 408. The second electrode 408 can be made of metal, such as silver, gold, or copper. A shape and a thickness of the second electrode 408 can be set as desired. The second electrode 408 can be located on and connected to the front surface 4060 or the rear surface 4062 of the carbon nanotube structure 406. The second electrode 408 is used to collect the current of the carbon nanotube structure 406.

The photovoltaic device 40 can further include at least one passivating layer 410. The passivating layer 410 can be made of silicon dioxide or silicon nitride. The shape and thickness of the passivating layer 410 can be set as desired. The passivating layer 410 can be located between the single crystal silicon substrate 404 and the carbon nanotube structure 406. The passivating layer 410 is used to reduce the combination speed of the electrons and holes at the interface of the single crystal silicon substrate 404 and the carbon nanotube structure 406, resulting in the improved photoelectric conversion efficiency of the photovoltaic device 40.

Referring to table 1, n-Si denotes the single crystal silicon substrate 404, which is an N-type single crystal silicon substrate, while p-Si denotes the single crystal silicon substrate 404, which is a P-type single crystal silicon substrate. The carbon nanotube structure 406 includes at least two stacked ordered carbon nanotube films. An angle between the aligned directions of the carbon nanotubes in any two adjacent carbon nanotube films is 90°. The photovoltaic device 40 can acquire the highest efficiency by adopting four ordered and stacked carbon nanotube films as the carbon nanotube structure 406.

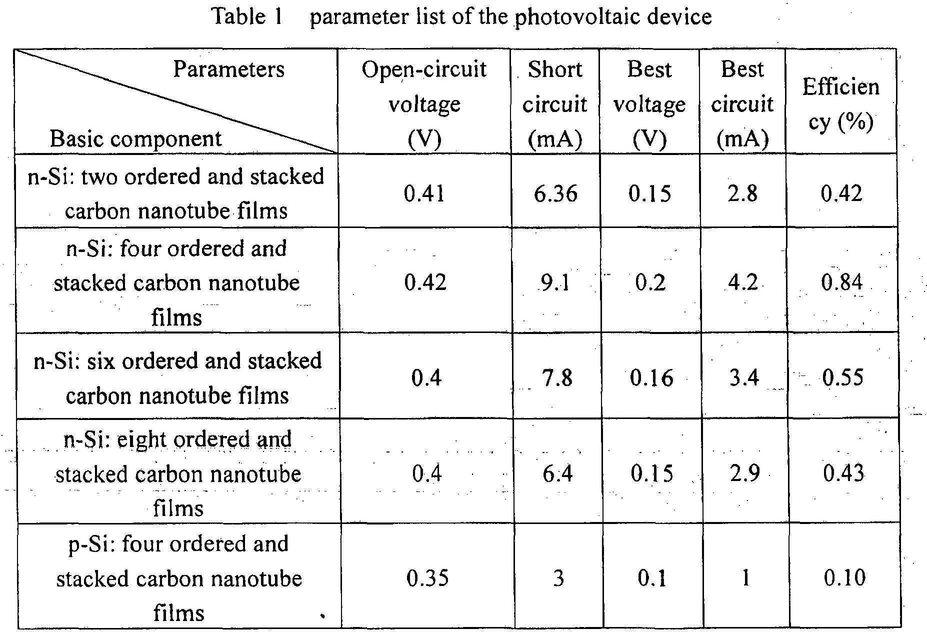

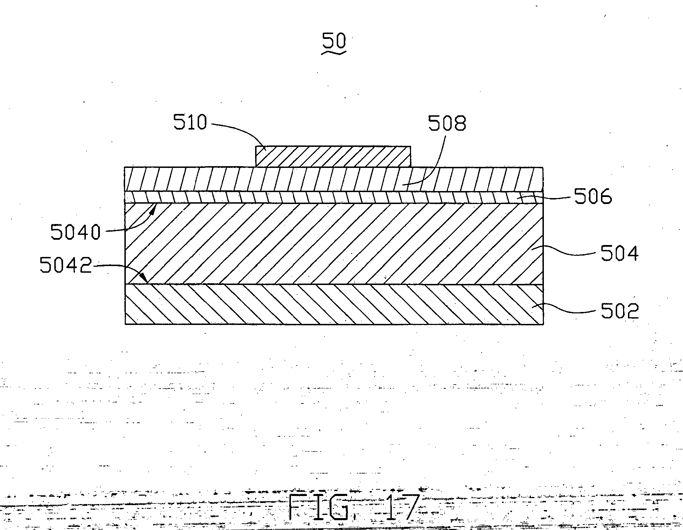

Referring to FIG. 17, a photovoltaic device 50 according to an example not part of the invention is shown. The photovoltaic device 50 includes a first electrode 502, a silicon substrate 504, an intrinsic layer 506, and a carbon nanotube structure 508.

The silicon substrate 504 is made of single-crystal silicon or polycrystalline silicon. The silicon substrate 504 has a front surface 5040 and a rear surface 5042, as shown in FIG. 17. A thickness of the silicon substrate 504 is in a range from about 200 µm to about 300µm. In the present example, the silicon substrate 504 is a n-type single-crystal silicon.

The intrinsic layer 506 is located on the front surface 5040 of the silicon substrate 504. The intrinsic layer 506 is made of silicon dioxide (SiO₂) or silicon nitride (Si₃N₄) as an insulating layer. The intrinsic layer 506 of the present example has a thickness of about 1 angstrom (Å) to about 30Å. Suitably, a thickness of the intrinsic layer 506 is about 10Å.

The first electrode 502 is located on and electrically connected to the rear surface 5042 of the silicon substrate 504 via ohmic contact, as shown in FIG. 17. The first electrode 502 can be made of metal, such as aluminum, magnesium or silver. In addition, the first electrode 502 has a thickness in a range from about 10µm to about 300µm.

The carbon nanotube structure 508 is located on the intrinsic layer 506. A plurality of heterojunctions is formed between the silicon substrate 504 and the carbon nanotube structure 508, achieving a conversion of solar radiation into electrical energy. The carbon nanotube structure 508 is the same as the carbon nanotube structure provided in the first embodiment. The carbon nanotube structure 508 is adapted to absorb light and the light then generates electrons and holes near the junction between the carbon nanotube structure 508 and the silicon substrate 504. The free electrons and holes are separated before they recombine with each other and sweep across in opposite directions due to the electric field. In addition, the intrinsic layer 506 between the silicon substrate 504 and the carbon nanotube structure of the carbon nanotube structure 508 is configured to further lower the speed of recombination of electrons and holes.

Furthermore, a plurality of metal particles can be dispersed in the carbon nanotube structure 508 to form a carbon nanotube composite structure. The carbon nanotube composite structure is the same as the carbon nanotube composite structure provided in the second embodiment. The carbon nanotube composite structure can be formed by coating a composited material of a mixture of carbon nanotube powders and metal powders on the silicon substrate 504.

Due to the excellent electrically conductive properties of the carbon nanotubes, the photovoltaic device 40 can have only one electrode. The photovoltaic device 50 of the present embodiment can further include a second electrode 510 located on the carbon nanotube structure 508. The second electrode 510 can be made of conductive material, such as silver, gold, or carbon nanotubes. The second electrode 510 can vary in thickness and shape.

In use, light striking the photovoltaic device 50 is absorbed by the carbon nanotube structure 508 and creates many mobile carriers (hole-electron pairs) at the heterostructure formed by the interface of the silicon substrate 504 and the carbon nanotube structure. Then, the hole-electron pairs are separated to form a plurality of holes and electrons by the electrostatic potential energy. The holes move across the silicon substrate 504 to the first electrode 502 and are collected by the first electrode 502. The electrons are transmitted and collected by the carbon nanotube structure 508. The electrons can further be collected by the second electrode 510. As a result, an electric current goes through an electrical circuit outside of the photovoltaic device 50.

Compared to conventional solar cells, the photovoltaic device in the disclosure has the following advantages: (1) the photovoltaic device has a high photoelectric conversion efficiency due to the excellent light absorbing properties of the carbon nanotube structure of the second electrode; (2) the photovoltaic device is durable due to the toughness of the carbon nanotube structure; (3) the light transmission is improved due to the interspaces between the adjacent carbon nanotubes of the carbon nanotube structure.

Finally, it is to be understood that the above-described embodiments are intended to illustrate rather than limit the disclosure. Variations may be made to the embodiments without departing from the disclosure as claimed. The above-described embodiments illustrate the scope of the disclosure but do not restrict the scope of the disclosure.

## Claims

1. A photovoltaic device (20) comprising:
a silicon substrate (202) having a front surface (2020) and a rear surface (2022), wherein a number of cavities (2024) are formed on the front surface (2020) of the silicon substrate (202);
a doped silicon layer(204) formed on inside surface of the cavities (2024) of the silicon substrate (202);
a first electrode (206) located on the rear surface (2022) of the silicon substrate (202); and
a second electrode (208) adjacent to the front surface (2020) of the silicon substrate(202), and the second electrode (208) comprising a carbon nanotube composite structure, wherein the carbon nanotube composite structure comprises a carbon nanotube structure and a plurality of metal particles (2082) uniformly dispersed in the carbon nanotube structure, a mass percentage of the metal particles (2082) in the carbon
nanotube composite structure being in a range from about 10% to about 30%, and an average diameter of the metal particles (2082) is in a range from about 1nm to about 10nm.

2. The photovoltaic device according to claim 1, wherein the carbon nanotube structure comprises at least one carbon nanotube film, at least one carbon nanotube cable or combination thereof.

3. The photovoltaic device according to claim 2, wherein the carbon nanotube structure comprises at least two carbon nanotube films (2080), and the at least two carbon nanotube films are stacked with each other and combined with each other by van der Waals attractive force therebetween.

4. The photovoltaic device according to any one of claims 2 to 3, wherein the carbon nanotube film comprises a plurality of oriented carbon nanotube segments joined end-to-end by van der Waals attractive force therebetween, and each carbon nanotube segment comprises a plurality of carbon nanotubes having a substantial same length and parallel to each other.

5. The photovoltaic device according to claim 2, wherein the carbon nanotube structure comprises a plurality of carbon nanotube cables located side by side, crossed or weaved together.

6. The photovoltaic device according to any one of claims 2 and 5, wherein the carbon nanotube cable comprises a plurality of carbon nanotubes wires, and each carbon nanotube wire comprises a plurality of carbon nanotubes joined end-to-end by van der Waals attractive force.

7. The photovoltaic device according to any one of claim 6, wherein the carbon nanotubes wires are twisted.

8. The photovoltaic device according to any one of claims 1 to 7, wherein a plurality of spaces (2084) are defined in the carbon nanotube structure.

9. The photovoltaic device according to any one of claims 1 to 8, further comprising an anti-reflection layer (222) located on the second electrode, and the anti-reflection layer is made of titanium dioxide or zinc aluminum oxide.

10. The photovoltaic device according to any one of claims 1 to 9, wherein the metal particles are selected from the group consisting of platinum particles, palladium particles, ruthenium particles, silver particles, gold particles, alloys thereof particles, and combinations thereof.

11. A photovoltaic device (20) comprising:
a silicon substrate (202) having a front surface (2020) and a rear surface (2022), wherein a number of cavities (2024) are formed on the front surface (2020) of the silicon substrate (202);
a doped silicon layer (204) formed on inside surface of the cavities (2024) of the silicon substrate (202);
a first electrode (206) located on the rear surface(2022) of the silicon substrate (202);
and
a second electrode (208) adjacent to the front surface (2020) of the silicon substrate (202), and the second electrode (208) comprising a plurality of carbon nanotube composite cables, wherein each of the plurality of carbon nanotube composite cables comprises a plurality of carbon nanotube wires (162) interlaced with a plurality of metal threads.

12. The photovoltaic device according to claim 11, wherein the metal threads are made of gold, silver, or copper.

## Patentansprüche

1. Eine photovoltaische Vorrichtung (20) aufweisend:
ein Silicium-Substrat (202) mit einer vorderen Oberfläche (2020) und einer hinteren Oberfläche (2022), wobei eine Anzahl von Hohlräumen (2024) in der vorderen Oberfläche (2020) von dem Silicium-Substrat (202) ausgebildet sind;
eine dotierte Silicium-Schicht (204) ausgebildet auf einer inneren Oberfläche von den Hohlräumen (2024) von dem Silicium-Substrat (202);
eine erste Elektrode (206), welche sich auf der hinteren Oberfläche (2022) von dem Silicium-Substrat (202) befindet; und
eine zweite Elektrode (208), welche an die vordere Oberfläche (2020) von dem Silicium-Substrat (202) angrenzt, und die zweite Elektrode (208) weist eine Kohlenstoffnanoröhrchenverbundstruktur auf, wobei die Kohlenstoffnanoröhrchenverbundstruktur eine Kohlenstoffnanoröhrchenstruktur und eine Vielzahl von Metallteilchen (2082) aufweist, welche gleichmäßig in der Kohlenstoffnanoröhrchenstruktur verstreut sind, wobei ein Massenanteil von den Metallteilchen (2082) in der Kohlenstoffnanoröhrchenverbundstruktur in einem Bereich von etwa 10 % bis etwa 30 % liegt und ein durchschnittlicher Durchmesser von den Metallteilchen (2082) in einem Bereich von etwa 1 nm bis etwa 10 nm liegt.

2. Die photovoltaische Vorrichtung gemäß Anspruch 1, wobei die Kohlenstoffnanoröhrchenstruktur zumindest einen Kohlenstoffnanoröhrchenfilm, zumindest ein Kohlenstoffnanoröhrchenkabel oder eine Kombination davon aufweist.

3. Die photovoltaische Vorrichtung gemäß Anspruch 2, wobei die Kohlenstoffnanoröhrchenstruktur zumindest zwei Kohlenstoffnanoröhrchenfilme (2080) aufweist und die zumindest zwei Kohlenstoffnanoröhrchenfilme mittels einer dazwischen wirkender Van-der-Waals-Anziehungskraft miteinander aufgestapelt und miteinander kombiniert sind.

4. Die photovoltaische Vorrichtung gemäß einem der Ansprüche 2 bis 3, wobei der Kohlenstoffnanoröhrchenfilm eine Vielzahl von orientierten Kohlenstoffnanoröhrchensegmenten aufweist, welche an den Enden mittels einer dazwischen wirkenden Van-der-Waals-Anziehungskraft miteinander verbunden sind und jedes Kohlenstoffnanoröhrchensegment eine Vielzahl von Kohlenstoffnanoröhrchen aufweist, welche im Wesentlichen dieselbe Länge haben und parallel zueinander sind.

5. Die photovoltaische Vorrichtung gemäß Anspruch 2, wobei die Kohlenstoffnanoröhrchenstruktur eine Vielzahl von Kohlenstoffnanoröhrchenkabeln aufweist, welche sich nebeneinander, gekreuzt oder zusammen verflechtet befinden.

6. Die photovoltaische Vorrichtung gemäß einem der Ansprüche 2 und 5, wobei das Kohlenstoffnanoröhrchenkabel eine Vielzahl von Kohlenstoffnanoröhrchendrähten aufweist und jeder Kohlenstoffnanoröhrchendraht eine Vielzahl von Kohlenstoffnanoröhrchen aufweist, welche an den Enden mittels einer Van-der-Waals-Anziehungskraft verbunden sind.

7. Die photovoltaische Vorrichtung gemäß Anspruch 6, wobei die Kohlenstoffnanoröhrchendrähte verdreht sind.

8. Die photovoltaische Vorrichtung gemäß einem der Ansprüche 1 bis 7, wobei eine Vielzahl von Räumen (2084) in der Kohlenstoffnanoröhrchenstruktur definiert sind.

9. Die photovoltaische Vorrichtung gemäß einem der Ansprüche 1 bis 8, weiter aufweisend eine Antireflexschicht (222), welche sich auf der zweiten Elektrode befindet, und die Antireflexschicht ist aus Titandioxid oder Zinkaluminiumoxid hergestellt.

10. Die photovoltaische Vorrichtung gemäß einem der Ansprüche 1 bis 9, wobei die Metallteilchen ausgewählt werden aus der Gruppe bestehend aus Platinteilchen, Palladiumteilchen, Rutheniumteilchen, Silberteilchen, Goldteilchen, Teilchen von Legierungen davon und Kombinationen davon.

11. Eine photovoltaische Vorrichtung (20) aufweisend:
ein Silicium-Substrat (202) mit einer vorderen Oberfläche (2020) und einer hinteren Oberfläche (2022), wobei eine Anzahl von Hohlräumen (2024) in der vorderen Oberfläche (2020) von dem Silicium-Substrat (202) ausgebildet sind;
eine dotierte Silicium-Schicht (204) ausgebildet auf einer inneren Oberfläche von den Hohlräumen (2024) von dem Silicium-Substrat (202);
eine erste Elektrode (206), welche sich auf der hinteren Oberfläche (2022) von dem Silicium-Substrat (202) befindet; und
eine zweite Elektrode (208), welche an die vordere Oberfläche (2020) von dem Silicium-Substrat (202) angrenzt, und die zweite Elektrode (208) weist eine Vielzahl von Kohlenstoffnanoröhrchenverbundkabeln auf, wobei jedes von der Vielzahl von Kohlenstoffnanoröhrchenverbundkabeln eine Vielzahl von Kohlenstoffnanoröhrchendrähten (162) aufweist, welche mit einer Vielzahl von Metallfäden verflochten sind.

12. Die photovoltaische Vorrichtung gemäß Anspruch 11, wobei die Metallfäden aus Gold, Silber oder Kupfer hergestellt sind.

## Revendications

1. Dispositif photovoltaïque (20) comprenant :
un substrat de silicium (202) ayant une surface avant (2020) et une surface arrière (2022), dans lequel un certain nombre de cavités (2024) sont formées sur la surface avant (2020) du substrat de silicium (202) ;
une couche de silicium dopé (204) formée sur la
surface interne des cavités (2024) du substrat de silicium (202) ;
une première électrode (206) située sur la surface
arrière (2022) du substrat de silicium (202) ; et
une seconde électrode (208) adjacente à la surface
avant (2020) du substrat de silicium (202) et la seconde électrode (208) comprenant une structure composite de nanotubes de carbone, dans lequel la structure composite de nanotubes de carbone comprend une structure de nanotubes de carbone et une pluralité de particules métalliques (2082) uniformément dispersées dans la structure de nanotubes de carbone, le pourcentage en masse des particules métalliques (2082) dans la structure composite de nanotubes de carbone se situant dans une plage d'environ 10 % à environ 30 % et le diamètre moyen des particules métalliques (2082) se situe dans la plage d'environ 1 nm à environ 10 nm.

2. Dispositif photovoltaïque selon la revendication 1, dans lequel la structure de nanotubes de carbone comprend au moins un film de nanotubes de carbone, au moins un câble de nanotubes de carbone ou une de leurs combinaisons.

3. Dispositif photovoltaïque selon la revendication 2, dans lequel la structure de nanotubes de carbone comprend au moins deux films de nanotubes de carbone (2080) et les au moins deux films de nanotubes de carbone sont empilés l'un sur l'autre et combinés l'un à l'autre par la force d'attraction de van der Waals s'appliquant entre eux.

4. Dispositif photovoltaïque selon l'une quelconque des revendications 2 à 3, dans lequel le film de nanotubes de carbone comprend une pluralité de segments de nanotubes de carbone orientés joints bout à bout par la force d'attraction de van der Waals qui s'applique entre eux et chaque segment de nanotubes de carbone comprend une pluralité de nanotubes de carbone ayant sensiblement la même longueur et parallèles l'un à l'autre.

5. Dispositif photovoltaïque selon la revendication 2, dans lequel la structure de nanotubes de carbone comprend une pluralité de câbles de nanotubes de carbone situés côte à côte, croisés ou tissés conjointement.

6. Dispositif photovoltaïque selon l'une quelconque des revendications 2 et 5, dans lequel le câble de nanotubes de carbone comprend une pluralité de fils de nanotubes de carbone et chaque fil de nanotubes de carbone comprend une pluralité de nanotubes de carbone joints bout à bout par la force d'attraction de van der Waals.

7. Dispositif photovoltaïque selon l'une quelconque de la revendication 6, dans lequel les fils de nanotubes de carbone sont torsadés.

8. Dispositif photovoltaïque selon l'une quelconque des revendications 1 à 7, dans lequel une pluralité d'espaces (2084) sont définis dans la structure de nanotubes de carbone.

9. Dispositif photovoltaïque selon l'une quelconque des revendications 1 à 8, comprenant en outre une couche anti-réfléchissante (222) située sur la seconde électrode et la couche anti-réfléchissante est constituée de dioxyde de titane ou d'oxyde de zinc et d'aluminium.

10. Dispositif photovoltaïque selon l'une quelconque des revendications 1 à 9, dans lequel les particules métalliques sont choisies dans le groupe constitué des particules de platine, des particules de palladium, des particules de ruthénium, des particules d'argent, des particules d'or, des particules de leurs alliages et de leurs combinaisons.

11. Dispositif photovoltaïque (20) comprenant :
un substrat de silicium (202) ayant une surface avant (2020) et une surface arrière (2022), dans lequel un certain nombre de cavités (2024) sont formées sur la surface avant (2020) du substrat de silicium (202) ;
une couche de silicium dopé (204) formée sur la
surface interne des cavités (2024) du substrat de silicium (202) ;
une première électrode (206) située sur la surface
arrière (2022) du substrat de silicium (202) ; et
une seconde électrode (208) adjacente à la surface
avant (2020) du substrat de silicium (202) et la seconde électrode (208) comprenant une pluralité de câbles composites de nanotubes de carbone, dans lequel chacun des câbles composites de nanotubes de carbone comprend une pluralité de fils de nanotubes de carbone (162) entrelacés avec une pluralité de fils métalliques.

12. Dispositif photovoltaïque selon la revendication 11, dans lequel les fils métalliques sont constitués d'or, d'argent ou de cuivre.
